# EUROPEAN PATENT SPECIFICATION

(11) **EP 2 807 422 B1**
(45) Date of publication and mention of the grant of the patent: **30.08.2017**
(21) Application number: 13740819.1
(22) Date of filing: 25.01.2013
(51) Int. Cl.: F21V 19/00, F21V 17/10, F21V 23/00, F21V 23/06, H01L 23/40, H01L 33/62, F21Y 115/10

(54) **DEVICE FOR SECURING A SOURCE OF LED LIGHT TO A HEAT SINK SURFACE**
VORRICHTUNG ZUR SICHERUNG EINER LED-LICHTQUELLE AN EINER KÜHLKÖRPEROBERFLÄCHE
DISPOSITIF POUR FIXER UNE SOURCE DE LUMIÈRE DEL POUR UNE SURFACE DE DISSIPATEUR DE CHALEUR

(30) Priority: 27.01.2012 US 201261591518 P
(43) Date of publication of application: 03.12.2014
(73) Proprietor: Ideal Industries, Inc., Sycamore, IL 60178 (US)
(72) Inventor: SCHROLL, Matthew David, Glendale Heights, Illinois 60139 (US); ZANTOUT, Alan Emad, Sycamore, Illinois 60178 (US)
(74) Representative: Samson & Partner Patentanwälte mbB
(86) International application number: PCT/US2013/023148
(87) International publication number: WO 2013/112838

(56) References cited:
- WO-A1-2007/128070
- WO-A1-2009/150590
- DE-A1-102010 031 312
- JP-A- 2003 068 129
- JP-A- 2010 097 926
- US-A- 5 143 331
- US-A1- 2004 066 142
- US-A1- 2005 180 157
- US-A1- 2005 226 002
- US-A1- 2010 046 232
- US-A1- 2011 019 409
- US-A1- 2011 019 409
- US-A1- 2011 063 842
- US-A1- 2011 273 895
- US-A1- 2011 273 895
- US-B1- 7 988 336

## Description

### Field of the Disclosure

The present description relates generally to the mounting of a light emitting diode (LED) light source, and more particularly, to a device for securing a source of LED light to a heat sink surface.

### Background of Related Art

Plastic devices which rely solely upon screw torque to secure a source of LED light, e.g., a LED light engine or a LED light module, to a surface of a heat sink are known in the art. Such known plastic devices, however, fail to provide a suitable force upon the source or LED light or provide for an even engagement between the source of LED light and the surface of the heat sink, whether when initially used or over time due to degradation of the plastic material.

US 7,988,336 B1 shows a mounting collar on a light fixture that provides a compressive force between an illumination module and the light fixture.

### Brief Description of the Drawings

FIG. 1 illustrates an exemplary device being used to secure a source of LED light to a surface of a heat sink.
FIG. 2 illustrates an exploded view of the assembly of FIG. 1.
FIG. 3 is a top view of the exemplary device of FIG. 1.
FIG. 4 is a side view of the exemplary device of FIG. 1.
FIG. 5 is a top view of a further exemplary device for securing a source of LED light to a surface of a heat sink.
FIG. 6 is a side view of the exemplary device of FIG. 5.
FIG. 7 illustrates an exploded view of a still further exemplary device being used to secure a source of LED light to a surface of a heat sink.
FIG. 8 is a top view of the exemplary device of FIG. 7.
FIG. 9 is a side view of the exemplary device of FIG. 7.
FIG. 10 is a top view of a yet further exemplary device for securing a source of LED light to a surface of a heat sink.
FIG. 11 is a side view of the exemplary device of FIG. 10.
FIG. 12 is a top view of a still further exemplary device for securing a source of LED light to a surface of a heat sink.
FIG. 13 is a top view of yet another exemplary device for securing a source of LED light to a surface of a heat sink.
FIG. 14 is a side view of the exemplary device of FIG. 13.
FIG. 15 is a top view of a yet further exemplary device for securing a source of LED light to a surface of a heat sink.
FIG. 16 is a perspective view of the device of FIG. 15.
FIG. 16A is perspective view of a still further example device for securing a source of LED light to a surface of a heat sink.
FIG. 17 is a side view of the device of FIG. 15.
FIG. 18 is an underside view of the device of FIG. 15.
FIG. 19 is an exploded view of an assembly including the device of FIG. 15.
FIG. 20 is a view of the assembly of FIG. 19 constructed.
FIG. 21 illustrates a still further exemplary device being used to secure a source of LED light to a surface of a heat sink.
FIG. 22 illustrates an exploded view of the assembly illustrated in FIG. 21.
FIG. 23 illustrates a perspective view of the device of FIG. 21 and an optional contact cartridge provided thereto.
FIG. 23A illustrates a perspective view of another example device for use in securing a source of LED light to a surface of a heat sink.
FIG. 24 illustrates a side view of the LED holder and contact cartridge of FIG. 23.
FIG. 25 illustrates an exploded view of the LED holder and contact cartridge of FIG. 23.
FIG. 26 illustrates an exploded view of a LED holding device and an optional electric contact base.
FIG. 27 illustrates a top view of the electric contact base of FIG. 26.
FIG. 28 illustrates a perspective view of the electric contact base of FIG. 26.
FIG. 29 illustrates a device having an optional accessory holding element.
FIG. 30 illustrates an exploded view of an assembly including the device of FIG. 29.
FIG. 31 illustrates the assembly of FIG. 30 assembled.
FIG. 32 illustrates a close-up view of the accessory holding elements of FIG. 29.

### Detailed Description

The following description of example methods and apparatus is not intended to limit the scope of the description to the precise form or forms detailed herein. Instead the following description is intended to be illustrative so that others may follow its teachings.

Described hereinafter are improved devices for securing a source of LED light to a mounting surface such as a heat sink surface. More particularly, the subject devices include a LED light source engaging surface that is arranged to engage a least a portion of a source of LED light wherein a force applying spring is integrated into the LED light engaging surface. The integrated force applying spring functions to generally, uniformly push the source of LED light against the surface of the heat sink thereby eliminating the screw torque concerns of the prior art devices. Similarly, the metallic nature of the device eliminates the thermal degradation concerns of the prior art devices. Thus, when the subject devices are attached to the heat sink, the devices will "sandwich" the source of LED light between the device and the heat sink 14 with the device flexing in the manner of a leaf spring so as to apply a force upon the source of LED light in a direction towards the heat sink with the result being a better thermal coupling between the source of LED light and the heat sink as compared to that provided by the prior art devices. By way of non-limiting example, the force applying leaf spring can be integrated into the LED light engaging surface, can be provided by providing the LED light engaging surface with one or more leaf-spring like mounting tabs, by providing the LED light engaging surface with a curved arrangement, etc.

While the foregoing provides a general description of the subject devices for securing a source of LED light to a heat sink and some advantages thereof, a better understanding of the objects, advantages, features, properties, and relationships of the subject devices will be obtained from the following detailed description and accompanying drawings which set forth illustrative examples and which are indicative of the various ways in which the principles of the invention may be employed.

Turning now to the figures, wherein like elements are referred to by like identifiers, illustrated are various examples of devices 10 that are usable to secure a source of LED light 12 to a mounting surface, such as a surface of a heat sink 14. As will become apparent from the description that follows, the subject devices 10 have, among others, the advantage of providing for a more even engagement between the source of LED light 12 and the surface of the heat sink 14. More particularly, the subject devices 10 are arranged and constructed to provide upon the source of LED light 12 forces that are distributed over at least a substantial portion of the source of LED light 12 which forces function to drive the source of LED light 12 onto the surface of the heat sink 14 in a more even manner as compared to prior art devices. Furthermore, the subject device 10 are preferably constructed from a material, such as a metal, whereby the force applying characteristics of the devices 10 will not substantially degrade over time, temperature (e.g., thermal cycling), and usage. Thus in some examples, the device 10 may have a monolithic metal construction.

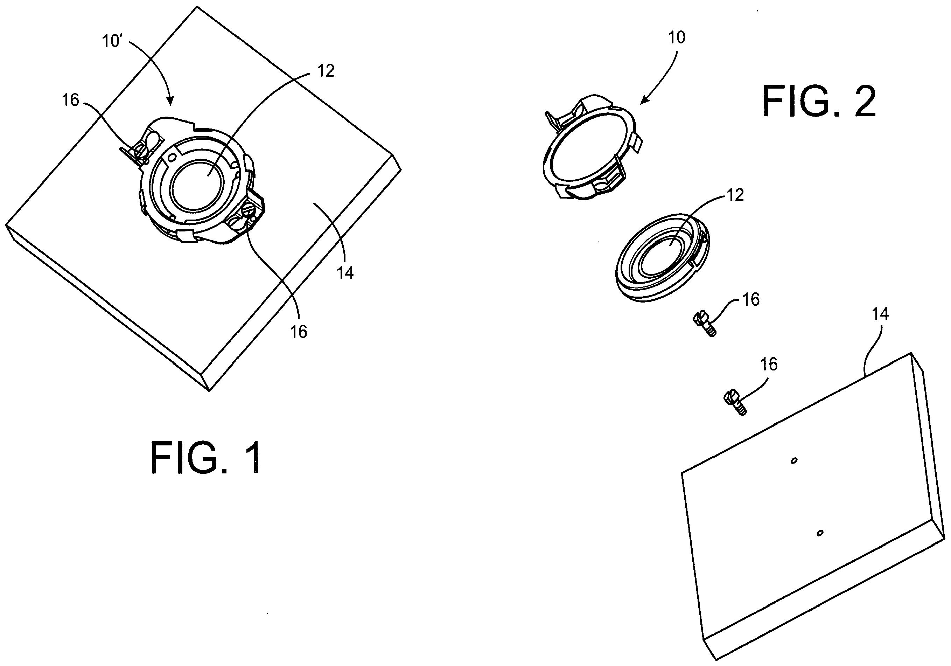

Considering now Figs. 1 and 2, FIG. 1 illustrates an exemplary device 10 being used to maintain a source of LED light 12, having a generally circular construction, to a surface of a heat sink 14. As shown in FIG. 1, the source of LED light 12 is disposed in between the device 10 and the surface of the heat sink 14 with the device 10 being secured to the surface of the heat sink 14 via use of fasteners 16. While the fasteners 16 are illustrated in the exemplary form of screws, it is to be appreciated that any form of fastener, particularly any form of fastener having an enlarged head portion (or other surface feature), may be used for this purpose. In addition, the fasteners could be formed as a part of the heat sink, e.g., the fasteners and heat sink could be die cast as a one piece element.

At least one continuous path between the surface of the heat sink 14 and the source of LED light 12 may be formed of metal. The continuous metallic path may provide or may help provide a force acting on the source of LED light 12 in a direction towards the surface of the heat sink 14. Moreover, the continuous metallic path may essentially provide a thermal conduit back to the surface of the heat sink 14. In some examples, once the surface of the heat sink 14 and the source of LED light 12 are installed, at least a portion of the continuous metallic path may be deflected or deflectable, as described further below (e.g., tabs 24). Further, in one example, the example continuous metallic path may include and/or terminate at the fasteners that secure the device 10 to the surface of the heat sink 14. Still further, in addition or in the alternative, the continuous metallic path may contact a surface of the source of LED light 12 that is opposite the surface of the heat sink 14.

For securing the source of LED light 12 to the surface of a heat sink 14, the device 10 is provided with an aperture 18 which is surrounded by an LED light source engaging surface 20. Apertures, such as the aperture 18, for instance, may be, for example and without limitation, holes, slots, and/or other openings, etc. The LED light source engaging surface 20 is sized and arranged to engage at least a portion of the source of LED light 12. In the example shown in Figs. 1-4, the LED light source engaging surface 20 is arranged to engage at least a portion of a corresponding surface of the source of LED light 12. For locating the source of LED light 12 between the device 10 and the heat sink 14, the device 10 may optionally include one or more LED light source locating surfaces 22. When utilized, the LED light source locating surfaces 22, which extend from the LED light source engaging surface 20 in a direction that would be towards the heat sink 14 when the device 10 is attached thereto, function to engage corresponding surfaces of the source of LED light 12.

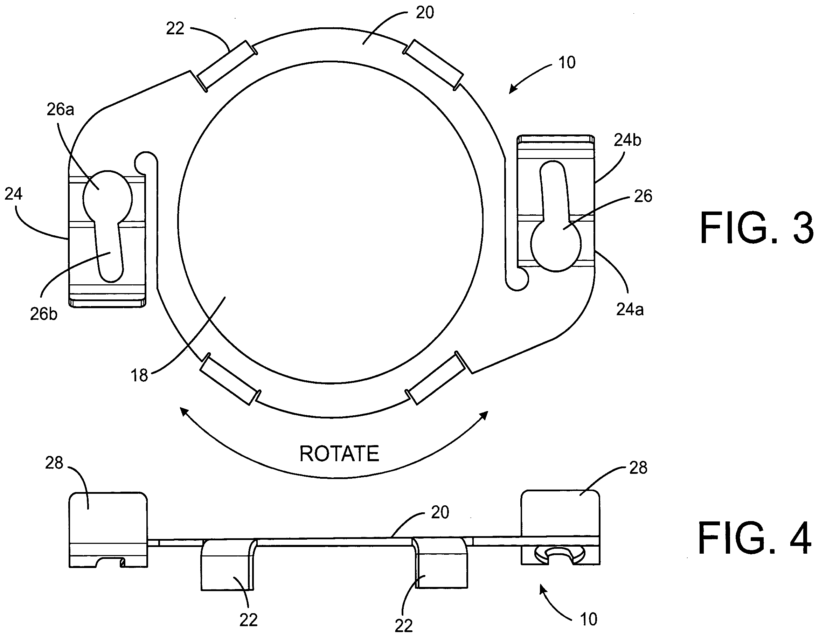

For applying the desired forces upon the source of LED light 12 when the device 10 is secured to the heat sink surface 14 via use of the fasteners 16, the LED light engaging surface 20 includes an integrated force applying spring. In the exemplary example of Figs. 1-4, the integrated force applying spring is in the form of at least a pair of resilient or leaf-spring like mounting tabs 24 each having a key-shaped, fastener accepting opening 26. As shown in Figs. 1-4, the mounting tabs 24 extend from opposed sides of the LED light source engaging surface 20. As particularly illustrated in FIG. 3, the mounting tabs 24 are preferably provided with a first portion 24a that extends from the LED light source engaging surface 20 at a first angle and a second portion 24b that then extends from the end of the first portion 24a at a second angle where the key-shaped fastener accepting opening 26 spans the first portion 24a and the second portion 24b.

To secure the device 10 upon the heat sink surface 14 and thereby secure the source of LED light 12 against the heat sink surface 14, the device 10 is first positioned such that the fastener 16 is received into a larger portion 26a of the key-shaped, fastener accepting opening 26 whereupon the device 10 is rotated to cause the fastener 16 to be moved into a narrower portion 26b of the key-shaped, fastener accepting opening 26 whereupon the device 10 is effectively locked in position. More particularly, as the device 10 is rotated, the head (or other surface feature) of the fastener 16 will be moved over a surface of the second portion 24a of the mounting tab 24 and the resilient or leaf-spring like nature of the mounting tab 24, acting against the head (or other surface feature) of the fastener 16, will cause the LED light source engaging surface 20 of the device 10 to generally, uniformly push the source of LED light 12 against the surface of the heat sink 14. To assist in the rotating of the device 10, e.g., to lock and unlock the source of LED light 12 against the heat sink surface 14, one or more turn assisting surfaces 28 may also be provided to the device 10. By way of example only, the turn assisting surfaces 28 may be surfaces that are formed so as to extend from the ends of the mounting tabs 24 in a direction that would be generally perpendicular to the heat sink 14 when the device 10 is attached thereto. It will be further appreciated that the example shown in Figs. 1-4 also has the advantage of not requiring the fasteners 16 to be removed from the heat sink when it is desired to remove the source of LED light 12 therefrom.

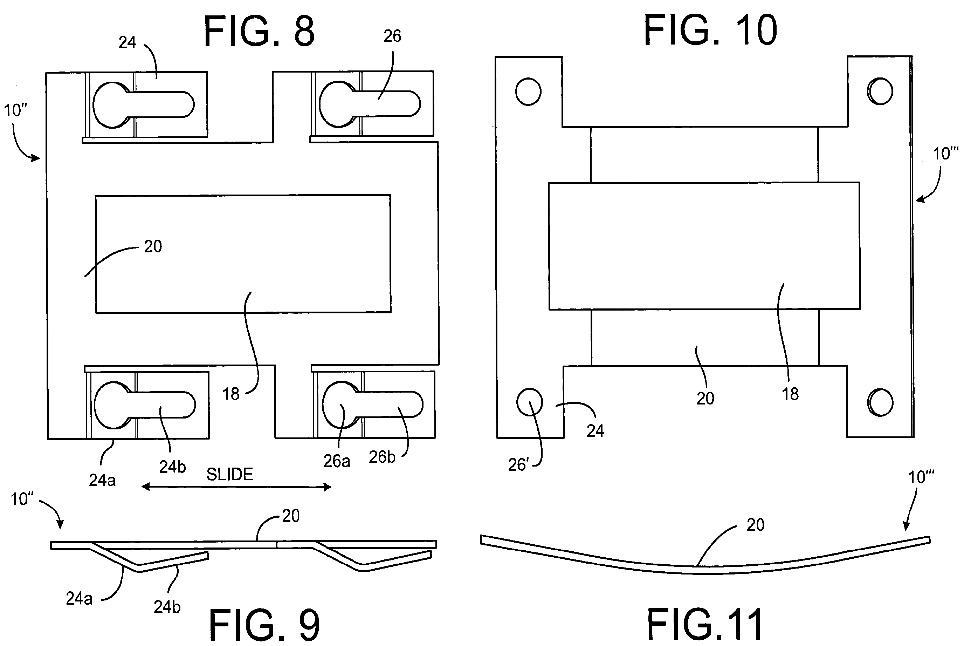

It is to be appreciated that the fastener accepting opening provided to the leaf-spring like mounting tabs 24 of the example shown in Figs. 1-4 may be in the form of otherwise conventional openings such as apertures 26' shown in FIG. 10 if so desired. In such a case, the openings 26' could be provided to any surface of the leaf-spring like mounting element that would allow the leaf spring to flex for the purposes above described.

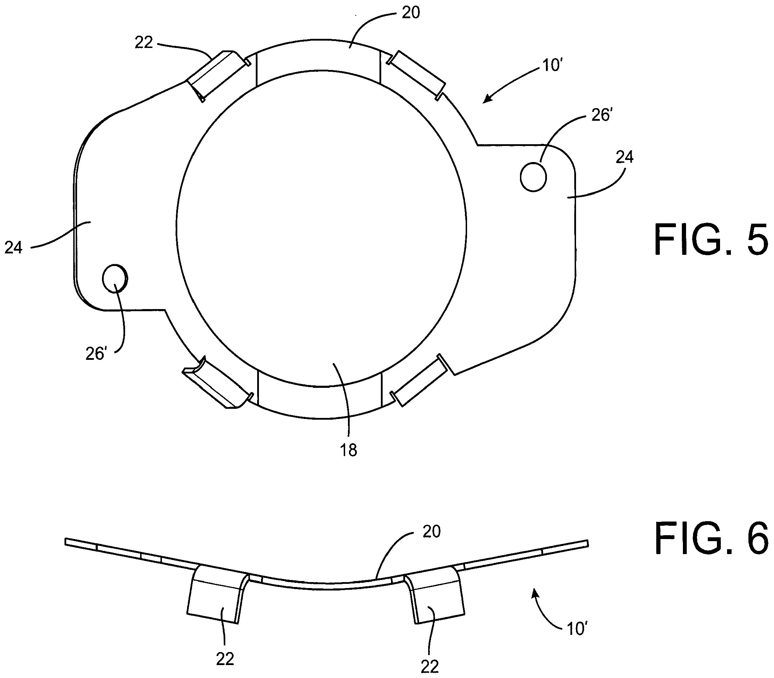

Considering now Figs. 5 and 6, a further device 10' is illustrated in which the LED light source engaging surface 20 of the example shown in Figs. 1-4 has been provided with an integrated spring by providing the LED light engaging surface 20 with a curved configuration when the device 10' is not under load. As particularly illustrated in FIG. 6, the LED light source engaging surface 20 is preferably curved from a center axis that is generally perpendicular to an axis formed between the mounting tabs 24. Because in such an arrangement the LED light source engaging surface 20 acts as a spring to apply the forces upon the source of LED light 12 when the device 10' is secured to the heat sink surface 14, in the example shown in Figs. 5 and 6, the mounting tabs 24 need not be provided with the bent, leaf-spring configuration that is utilized in connection with the example shown in Figs. 1-4. Such leaf-spring mounting tabs could, however, be utilized if desired. Furthermore, in the example shown in Figs. 5 and 6, fasteners 16 can be inserted into key-shaped openings as previously described or can be inserted into otherwise conventional fastener accepting opening 26'. In either case, when attached via use of the fasteners 16 to the heat sink 14, the LED light source engaging surface 20 will flex and thereby cause the LED light source engaging surface 20 to apply a force upon the source of LED light 12 to generally, uniformly push the source of LED light 12 against the surface of the heat sink 14.

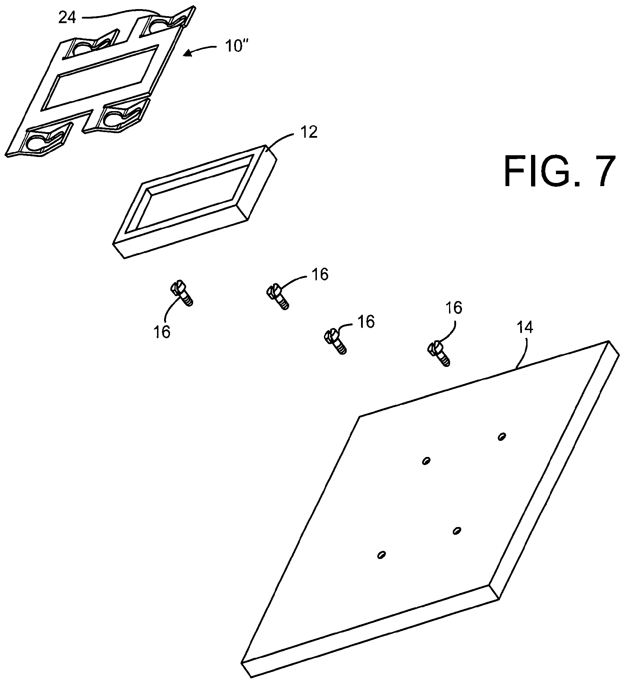

Considering now Figs. 7-9, a further device 10" is illustrated in which the generally planar LED light source engaging surface 20 of the example shown in Figs. 1-4 has been provided with a shape for engaging a source of LED light 12 having a generally rectangular configuration. As with the example shown in Figs. 1-4, the device 10" includes an integrated spring construction in the form of one or more leaf-spring like engagement tabs 24. The engagement tabs 24 are again arranged to cooperate with a head (or other surface feature) of a fastener 16 in the manner described above, i.e., to flex and to thereby cause the LED light source engaging surface 20 to apply a force upon the source of LED light 12 to generally, uniformly push the source of LED light 12 against the heat sink 14. Because of the rectangular configuration of the LED light source 12 in this assembly, rather than allow for the device 10" to be rotated into and out of engagement with the fasteners 16, the leaf-spring like engagement tabs 24 are arranged to allow the device 10" to be slid linearly into and out of engagement with the fasteners 16.

Considering now Figs. 10 and 11, a still further device 10'" is illustrated in which the LED light source engaging surface 20 of the example shown in Figs. 7-9 has been provided with an integrated spring by providing the LED light source engaging surface 20 with a curved configuration when the device 10'" is not under load. As particularly illustrated in FIG. 11, the LED light source engaging surface 20 is curved from a center axis that is generally intermediate the pairs of mounting tabs 24. As will be appreciated, in such an arrangement, the LED light source engaging surface 20 acts as a spring to apply the forces upon the source of LED light 12 when the device 10'" is secured to the heat sink surface 14. As before, in the example shown in Figs. 10 and 11, the mounting tabs 24 may optionally omit the bent, leaf-spring configuration that is utilized in connection with the example shown in Figs. 7-9. Similarly, the mounting tabs 24 may optionally omit the key-shaped openings 26 and may instead utilize otherwise conventional fastener accepting opening 26'. In either instance, when the device 10 "' is attached to the heat sink 14, the LED light source engaging surface 20, owing to its integrated spring configuration, will function to apply a force upon the source of LED light 12 to generally, uniformly push the source of LED light 12 against the surface of the heat sink 14.

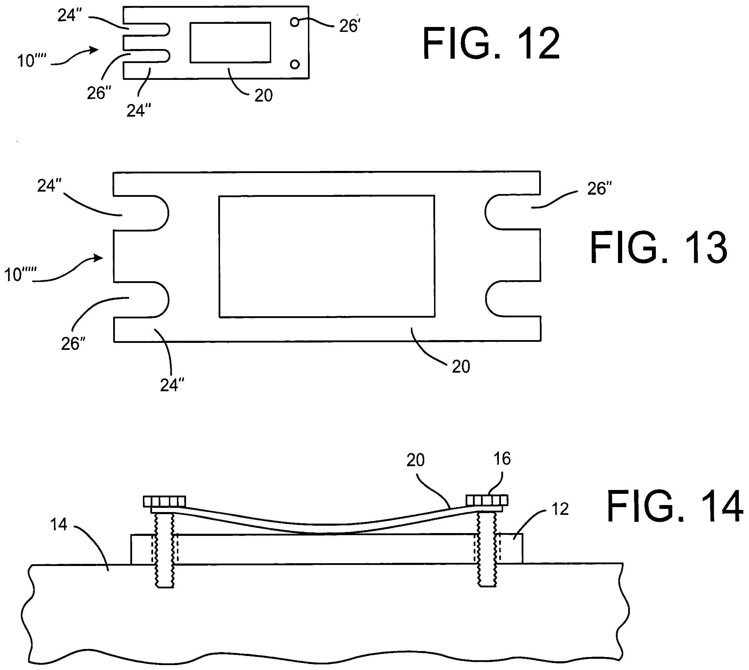

In FIG. 13, a further device 10""' is illustrated which provides slots 26" adjacent to mounting elements 24". In this manner, when a fastener 16 is received into the slots 26", e.g., by being slid therewithin, the integrated spring provided to the LED light engaging surface 20, e.g., as provided by the curved surface of the LED light engaging surface 20 as shown in FIG. 14, will function to generally, uniformly push the source of LED light 12 against the surface of the heat sink 14. While not shown, in such examples, the mounting elements could be provided with leaf-spring like or flexible elements in addition to or alternatively to providing the LED light engaging surface 20 with an integrated spring curve as noted above. In addition, as illustrated in FIG. 12, a still further device 10"" may be provided with slots 26" for receiving fasteners 16 as well as apertures 26'. As will be understood, the use of such slots 26" may allow for the removal of the device and/or removal of the source of LED light from under the device without requiring removal of all of the fasteners 16 from the heat sink 14.

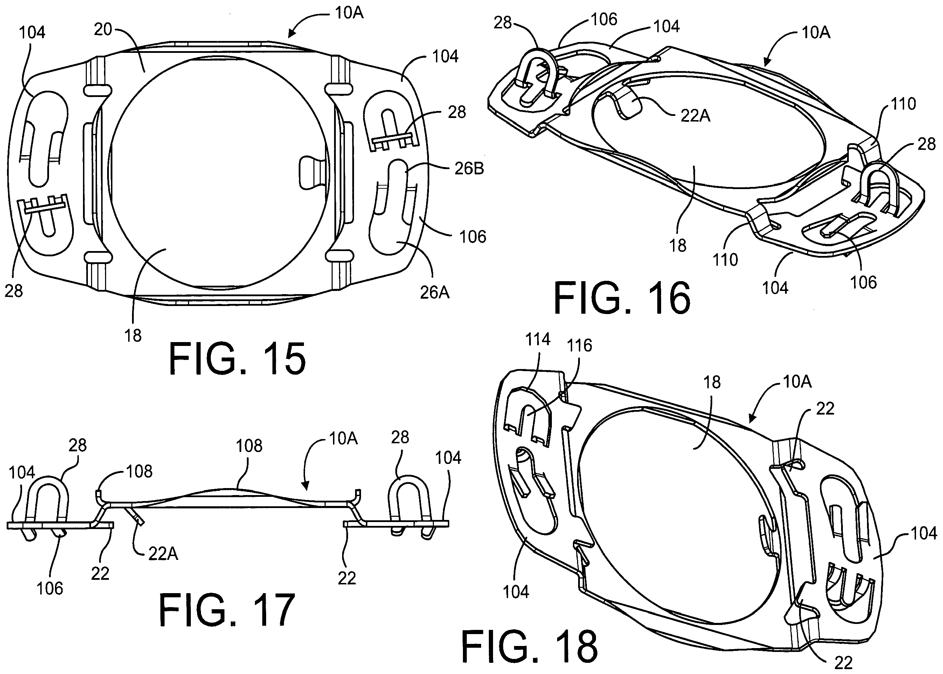

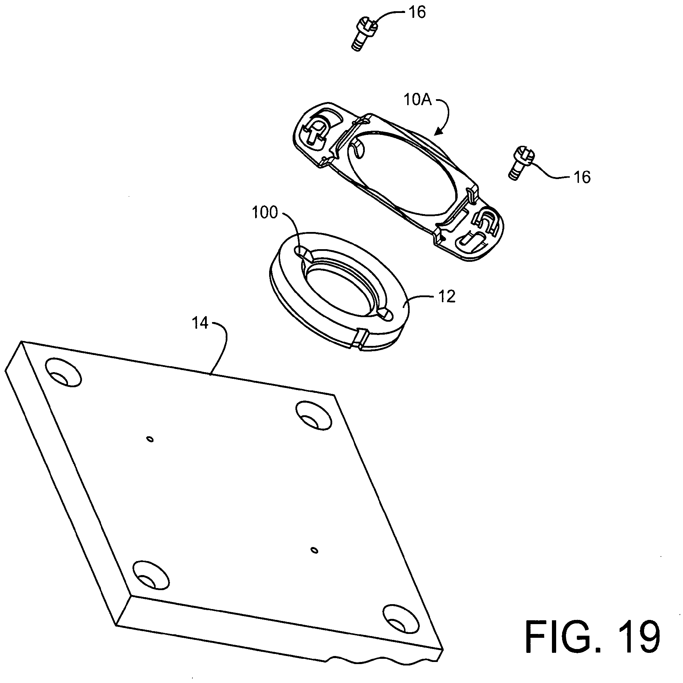

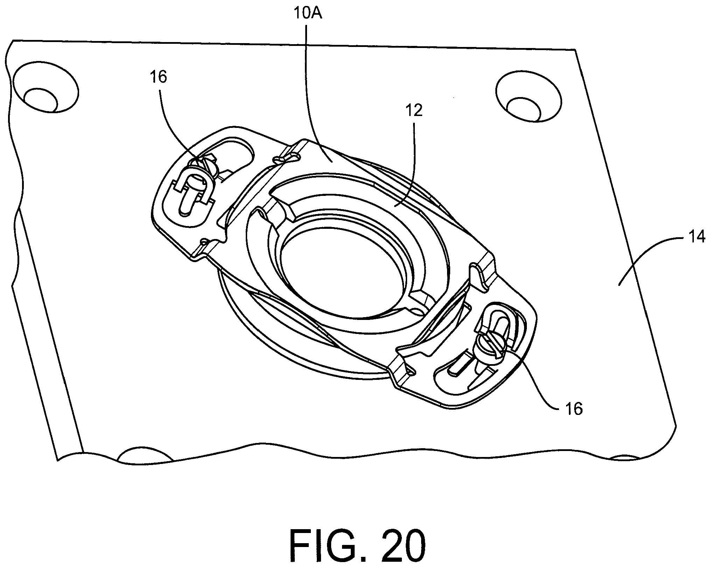

Considering now Figs. 15 - 20, a further exemplary device 10A is illustrated for use in maintaining a source of LED light 12 against a surface of a heat sink 14. As before, the source of LED light 12 will be disposed between the device 10A and the surface of the heat sink 14 with the device 10A being secured to the surface of the heat sink 14 via use of fasteners 16. The device 10A is provided with an aperture 18 which is surrounded by an LED light source engaging surface 20. The LED light source engaging surface 20 is sized and arranged to engage at least a portion of the source of LED light 12. In the example shown in Figs. 15 - 20, the LED light source engaging surface 20 is arranged to engage at least a portion of a corresponding surface of the source of LED light 12. For locating the source of LED light 12 between the device 10A and the heat sink 14, the device 10A may include one or more LED light source locating surfaces 22A. More particularly, the LED light source locating surfaces 22A may be elastically deflected to hold the LED light source to the device 10A before positioning to the LED mounting surface 20 to aid assembly and field replacement. When utilized, the LED light source locating surfaces 22A, which extend from the LED light source engaging surface 20 in a direction that would be towards the heat sink 14 when the device 10A is attached thereto, function to engage a corresponding feature 100 provided to the source of LED light 12. The device 10A may also be provided with light source engaging surfaces 22 for engaging corresponding sides of the source of LED light 12.

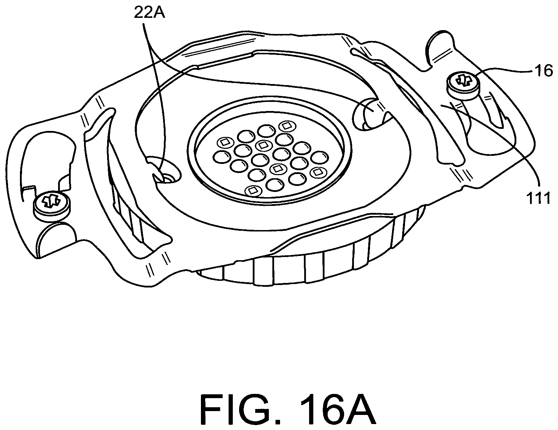

For applying the desired forces upon the source of LED light 12 when the device 10A is secured to the heat sink surface 14 via use of the fasteners 16, the device 10A is provided with a pair of opposed mounting elements 104 each of which carries a key-shaped, fastener accepting opening 26. As shown in Figs. 15 - 20, the mounting elements 104 preferably extend from opposed sides of the LED light source engaging surface 20. Thus, to secure the device 10A upon the heat sink surface 14 and thereby secure the source of LED light 12 against the heat sink surface 14, a fastener 16 is first received into a larger portion 26a of the key-shaped, fastener accepting opening 26 whereupon the device 10 is moved to cause the fastener 16 to be moved into a narrower portion 26b of the key-shaped, fastener accepting opening 26. More particularly, as the device 10 is rotated, the head (or other surface feature) of the fastener 16 will be moved over a surface 106 associated with the mounting element 104 and the head (or other surface feature) of the fastener 16, acting in cooperation with the mounting element 104, will drive the mounting element towards the heat sink 14 and thereby cause the LED light source engaging surface 20 of the device 10A to generally, uniformly push the source of LED light 12 against the surface of the heat sink 14. To assist in the rotating of the device 10A, e.g., to lock and unlock the source of LED light 12 against the heat sink surface 14, one or more turn assisting surfaces 28 may also be provided to the device 10. By way of example only, the turn assisting surfaces 28 may be surfaces that are formed so as to extend from the mounting elements 104 in a direction that would be generally perpendicular to the heat sink 14 when the device 10A is attached thereto. Once assembled, one or more anti-rotation features 111 (*e.g.,* a bump) such as that shown in Fig. 16A, for example, may help prevent the fastener 16 from rotating with respect to the device 10A. The anti-rotation feature 111 shown in Fig. 16A may contact an underside of a head of the fastener 16. It will be again be appreciated that the example shown in Figs. 15 - 20 has the advantage of not requiring the fasteners 16 to be removed from the heat sink when it is desired to remove the source of LED light 12 therefrom. The device 10A may additionally be provided with rib-like elements 108 to assist in maintaining the rigidity of the LED mounting surface 20 as the legs 110 leading between the LED mounting surface 20 and the mounting elements 104 are caused to flex when the device 10A is secured upon the heat sink 14. Furthermore, because the example illustrated in Figs. 15-20 is provided with an opening 114 (as a result of the manufacturing process) which is not intended to be used to receive a fastener 16, the opening 114 is provided with an element 116 that is intended to inhibit the introduction of a fastener 16 into the opening 114.

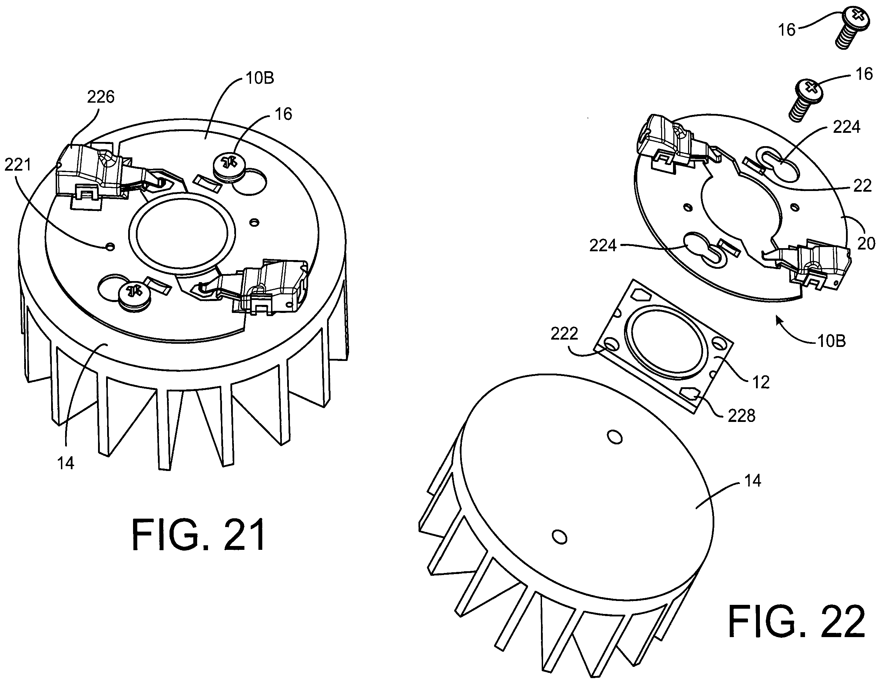

Considering now Figs. 21- 25, a further exemplary device 10B is illustrated. The device 10B is used to maintain a source of LED light 12 upon a surface of a heat sink 14. As shown in Figs. 21 and 22, the source of LED light 12 is disposed in between the device 10B and the surface of the heat sink 14 with the device 10B being secured to the surface of the heat sink 14 via use of fasteners 16 or other feature of the mounting surface. Generally, when the device 10B is attached to the heat sink 14, e.g., by being screwed down thereupon, the device 10B functions to "sandwich" the source of LED light 12 between the device 10B and the heat sink 14. Though in its free state the device 10B is planar, when under load the device 10B flexes and acts as a single leaf spring to thereby provide the securing force.

More particularly, for securing the source of LED light 12 to the surface of a heat sink 14, the device 10B is provided with an aperture 18 which is surrounded by an LED light source engaging surface 20. The LED light source engaging surface 20 is sized and arranged to engage at least a portion of the source of LED light 12. In the example shown in Figs. 21-25, the LED light source engaging surface 20 is arranged to engage at least a portion of a corresponding surface of the source of LED light 12. For locating the source of LED light 12 between the device 10B and the heat sink 14, and for preventing rotation of the source of LED light 12, the device 10B may optionally include one or more LED light source locating surfaces 22. When utilized, the LED light source locating surfaces 22 extend towards the heat sink 14 and are located at positions whereby the LED light source locating surfaces 22 will be able to engage with corresponding surfaces of the source of LED light 12. In addition or alternatively, and for these same purposes, the device 10B may be provided with protuberances 221 which are sized and arranged to engage with corresponding recesses 222 provided to the source of LED light 12.

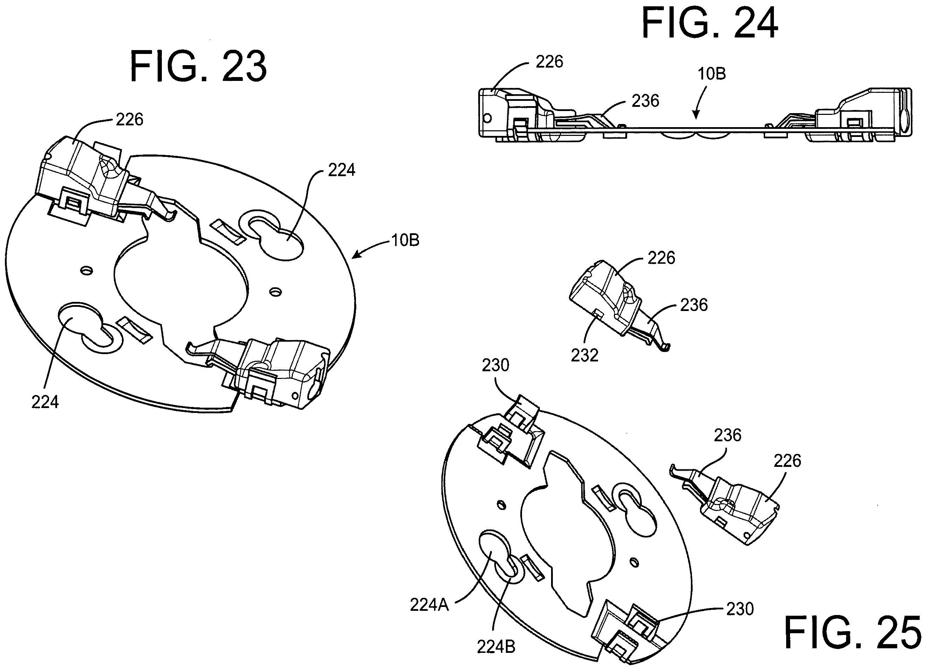

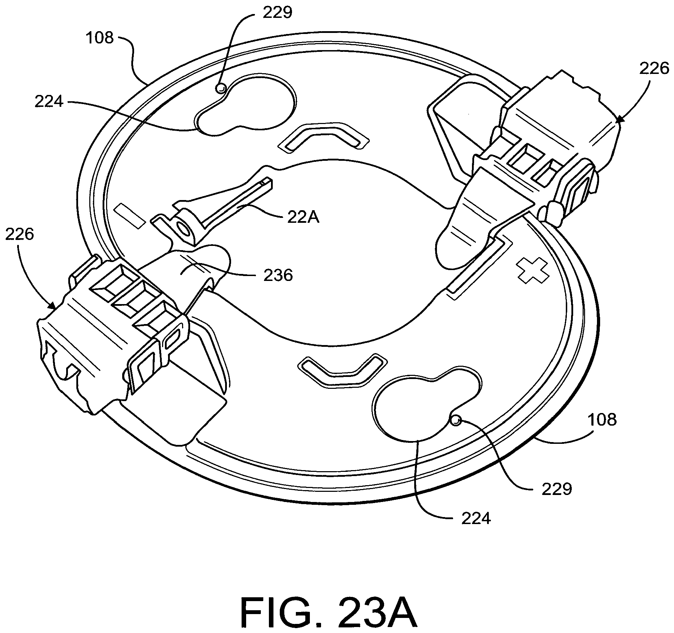

For applying the desired forces upon the source of LED light 12 when the device 10B is secured to the heat sink surface 14 via use of the fasteners 16, the LED light engaging surface 20 includes key-shaped fastener accepting openings 224. As shown in the figures, the fastener accepting openings 224 include a first portion 224A which is sized larger than the head (or other surface feature) of the fastener 16 (to thereby allow the device 10A to be removed from the heat sink 14 without requiring removal of the fasteners 16) and a second portion which is sized smaller than the head (or other surface feature) of the fastener 16 (to thereby hold the device 10A against the heat sink 14 via the cooperation of the head (or other surface feature) of the fasteners 16 and the LED light engaging surface 20). It should be understood that one advantage of the openings, such as the openings 224 in Fig. 23 or the openings 26, 26A in Figs. 8 and 15, for example, is to receive screws inserted into the heat sink surface 14 before the device 10 is installed. While not required, the area adjacent to the first portion 224A could be provided with an angled surface to thereby force the device 10A downwardly toward the heat sink 14 when the device 10B is turned relative to the fasteners 16, i.e., the device 10A is moved to cause the fasteners 16 to transition from the first portion 224A to the second portion 224B of the fastener accepting opening 224. More particularly, to secure the device 10B upon the heat sink surface 14 and thereby force the source of LED light 12 against the heat sink surface 14, the device 10B is first positioned such that the fastener 16 is received into a larger portion 224A of the key-shaped, fastener accepting opening 224 whereupon the device 10B is rotated to cause the fastener 16 to be moved into the narrower portion 224B of the key-shaped, fastener accepting opening 224. As the device 10B is rotated in this manner, the fastener 16 will be moved into engagement with the LED light engaging surface 20 and the device 10B, acting against the fastener 16, will generally, uniformly push the source of LED light 12 against the surface of the heat sink 14. As before, other fastener accepting openings can be utilized with this example to achieve the same results.

With reference to device 10B, although applicable to other of the described devices, the device 10B may be optionally provided with one or more electrical connector sub-assemblies 226. The connector sub-assemblies 226 may be integral with the device 10B or removeably attached to the device 10B, such as by being snap fit thereto - for example via cooperation of leaf springs 230 used to engage recesses 232 formed in the housing of the connector sub-assemblies 226 as illustrated in Figs. 21-25. The connector subassemblies 226 may be attached to either side of the device 10B depending on the requirements of the application. If located on the same side of the device 10B as the mounting surface 20, the connector subassemblies 226 may be disposed within or partially within the mounting surface 20 to provide a low-profile solution. As such, the connector subassemblies 226 may be said to break the plane of the mounting surface 20. The connector sub-assemblies 226 function to provide a means for a wire to be electrically coupled to an electrical contact pad 228 of the source of LED light 12. To this end, the connector sub-assemblies 226 include an electrical connector element (which is preferably insulated via the material of housing or other material) having at least one resilient first end 236 which is generally biased so as to engage a corresponding one of the electrical contact pads 228 of the source of LED light 12 when the source of LED light 12 is installed with the device 10B and at least one second end for accepting a wire. Without limitation, the at least one second end of the electrical connector element may provide for a crimp connection to a wire, a clamping connection to a wire, a push-in connection to a wire, and the like. Moreover, in one example, such as that shown in Fig. 23A for instance, the connector sub-assemblies 226 may be flexing insulators having resilient first ends 236 that extend to and/or over the electrical contact pad 228 of the source of LED light 12. In addition, in the example shown in Fig. 23A, the device 10A includes anti-rotation features 229 near the fastener accepting openings 224 to help prevent the fasteners 16 from loosening. Still further, as disclosed above, the device 10A may include one or more LED light source locating surfaces 22A for locating the source of LED light 12 between the device 10A and the heat sink 14. To aid assembly and field replacement, the LED light source locating surfaces 22A may be elastically deflected to hold the LED light source to the device 10A before positioning to the LED mounting surface 20.

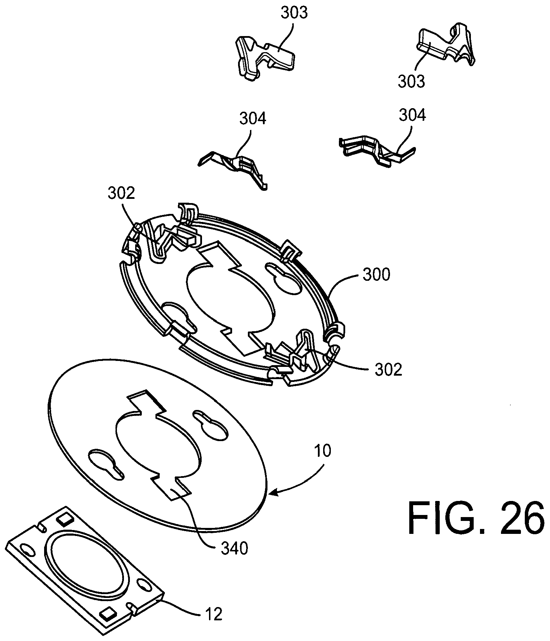

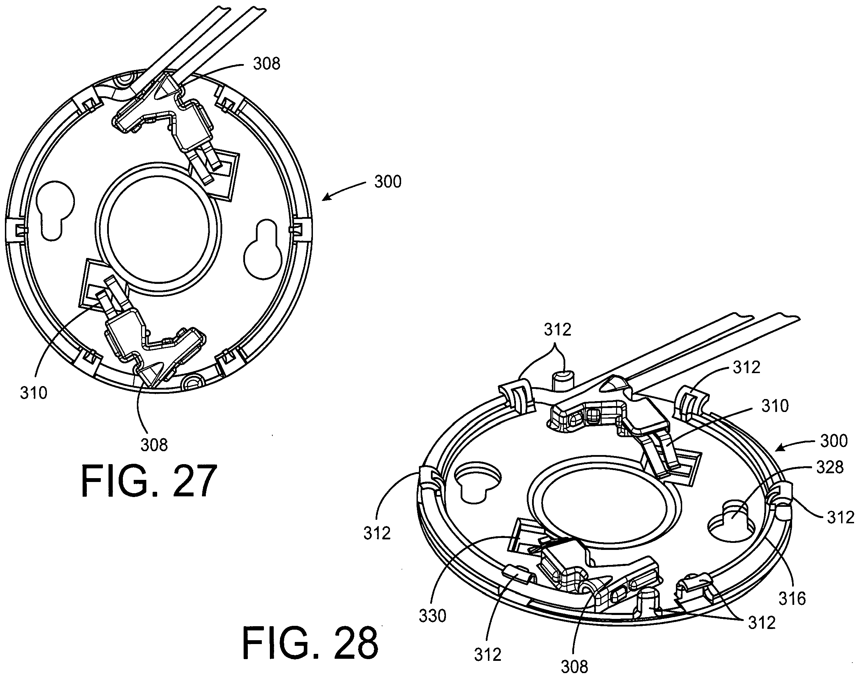

In a yet further example illustrated in Figs. 26-28, a device 10 may be installed between the source of LED light 12 and an electrical contact base 300. The electrical contact base 300 supports one or more housing elements 302, which are capped via use of cover elements 303, in which are carried electrical contact elements 304. In a preferred example, the electrical contact base 300 is constructed from a plastic or other insulating material. The electrical contact elements again provide a means for a wire - fed into a wire port 308 of the housing elements 302 - to be electrically coupled to an electrical contact pad 228 of the source of LED light 12. To this end, the electrical contact elements 304 have at least one resilient first end 310 which is generally biased so as to engage a corresponding one of the electrical contact pads 228 of the source of LED light 12 when the source of LED light 12 is installed with the device 10 and at least one second end for accepting a wire. In certain circumstances, the electrical contact elements 304 may be provided with at least two resilient first ends 310 as illustrated to thereby allow the same assembly to be used with differently oriented electrical contact pads 228 of different sources of LED light 12. While the second end of the electrical connector element is illustrated as providing a push-in type connection, it will be appreciated that the at least one second end of the connector may provide for a crimp connection to a wire, a clamping connection to a wire, or the like without limitation.

For securing wire to the electrical contact base 300, one or more securing elements 312 are carried by the electrical contact base 300. The securing elements 312 may be integrally formed with the electrical contact base 300 or be elements added thereto. The securing elements 312 are also preferably provided with some resiliency to thereby allow wire placed therein to be clamped at a location that is spaced from the opening 18. The securing elements 312 may be arranged adjacent to a guide channel 316 also formed on the electrical contact base 300. As will be appreciated, the electrical contact base 300 includes key-shaped elements 328 or the like for accepting fasteners 16 as well as openings 330 through which the electrical contacts are able to contact with the contact pads 228 of the source of LED light 12. If an electrical contact base 300 is to be utilized with a device 10, it will also be understood that the device 10 should also be provided with cutouts or openings 340 to allow the electrical contacts to contact the contact pads 228 of the source of LED light 12 as seen in FIG. 26.

It should be understood that although components for electrical connections are generally shown on the mounting surface 20 of the device 10, the present disclosure contemplates disposing these components, such as the one or more housing elements 302, the electrical contact elements 304, and the connector subassemblies 226, for example, on a surface of the device 10 opposite the mounting surface 20, or partially within the mounting surface 20.

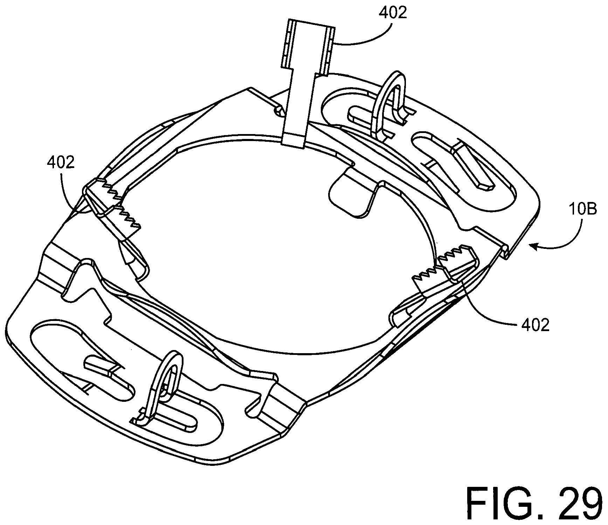

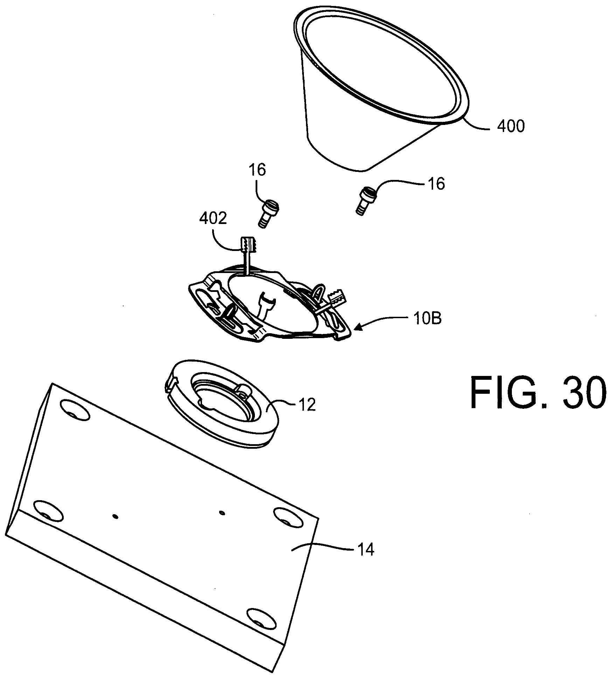

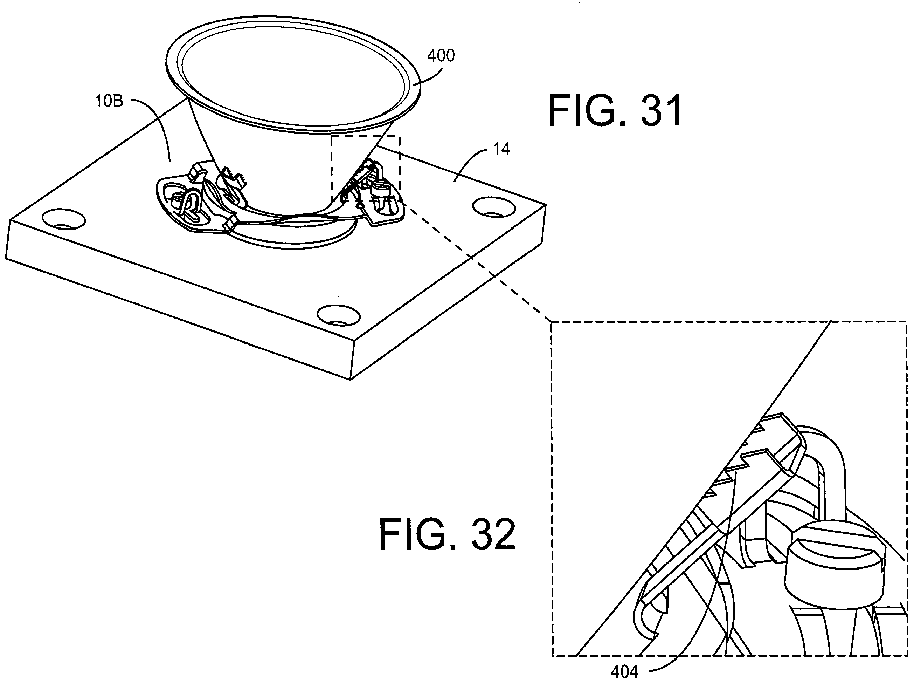

For use in holding and centering a reflector 400 or other accessory, the device 10 may be provided with optional reflector securing elements 402 as shown in Figs. 29-32. The securing elements 402 are resiliently coupled to the device 10 and provide a clamping force upon the reflector 400 when the reflector 400 is positioned therebetween. To assist in maintaining the reflector 400 upon the device 10, the securing elements 402 may be provided with teeth 404 for gripping the outer surface of the reflector 400.

Although certain example methods and apparatus have been described herein, the scope of coverage of this patent is not limited thereto. While specific examples of the subject invention have been described in detail, it will be appreciated by those of ordinary skill in the art that various modifications and alternatives to those details could be developed in light of the overall teachings of this disclosure. It will therefore be appreciated that features described with respect to the various examples are not to be limited to any particular example but may be freely used across examples where applicable. Additionally, it will be appreciated that the size, shape, arrangement, and/or number of components illustrated and described can be changed as necessary to meet a given need. Accordingly, this patent covers all methods, apparatus, and articles of manufacture fairly falling within the scope of the appended claims either literally or under the doctrine of equivalents.

## Claims

1. A device for releasably securing a LED light module, having one or more sources of LED light (12), on a mounting surface (14), comprising:
a monolithic member (10) constructed from a resilient, metallic material having an aperture (18) for the one or more sources of LED light (12) wherein the aperture (18) is completely surrounded by a planar LED light module engaging surface (20) arranged to releasably engage corresponding surfaces of the LED light module (12), the monolithic member (10) further having an integrated force applying spring in the form of at least a pair of resilient or leaf-spring like mounting tabs (24) each having a key-shaped fastener receiving opening (26),
wherein the at least a pair of mounting tabs (24) extend from opposed sides of the LED light source engaging surface (20),
wherein an engagement between the mounting tabs (24) and a corresponding fastener (16) with the corresponding surfaces of the LED light module (12) positioned in engagement with the planar LED light module engaging surface (20) places the planar LED light module engaging surface (20) under load such that the planar LED light module engaging surface (20) applies a generally uniform force upon the corresponding surface of the LED light module (12) to secure the LED light module (12) on the mounting surface (14) while providing at least one continuous metallic path between the mounting surface (14) and the LED light module (12).

2. A device as recited in claim 1, wherein each of the at least a pair of mounting tab (24) is provided with a first portion (24a) that extends from the LED light source engaging surface 20 at a first angle and a second portion 24b that then extends from the end of the first portion 24a at a second angle where the key-shaped fastener accepting opening (26) spans the first portion (24a) and the second portion (24b).

3. A device as recited in claim 1, wherein the device is arranged to be releasably lockable in an installed position in which the LED light module (12) is secured to the mounting surface (14).

4. A device as recited in claim 3, wherein the device is adapted to be slid in a generally parallel direction relative to the mounting surface (14) to transition the device from a free position to the installed position.

5. A device as recited in claim 3, wherein the device is adapted to be rotated in a plane parallel to the mounting surface (14) to transition the device from a free position to the installed position.

6. A device as recited in claim 1, further comprising a set of deflectable arms (22) coupled to the monolithic member (10) for grasping an accessory attachable to the device.

7. A device as recited in claim 1, further comprising at least one electrically insulating housing carried by the monolithic member (10), the at least one electrically insulating housing having an electrical contact element disposed therein, the electrical contact element being arranged to be electrically coupled to a correspond electrical contact of the LED light module (12) and to remain electrically insulated from monolithic member (10).

8. A device as recited in claim 7, wherein the at least one electrically insulating housing is attached to a side of the monolithic member (10) that is closer to the mounting surface (14).

9. A device as recited in claim 7, wherein the electrical contact element comprises one or more portions that are generally biased to engage the corresponding electrical contact of the LED light module (12).

10. A device as recited in claim 7, wherein the electrical contact element is connected to one or more wires.

11. A device as recited in claim 10, wherein the electrical contact element comprises at least one push-in type connector for engaging the one or more wires.

12. A device as recited in claim 10, wherein the device further comprises one or more routing elements for positioning the one or more wires through a path.

13. A device as recited in claim 1, further comprising one or more locating features associated with the monolithic member (10) co-operable with a feature of the LED light module (12) for use in locating the LED light module (12) in engagement with the LED light module engaging surface (20).

14. A device as recited in claim 13, wherein at least one of the one or more locating features is deflected when the LED light module (12) is placed into engagement with the LED light module engaging surface (20).

15. A device as recited in claim 13, wherein the one or more locating features holds and secures the LED light module (12) to the monolithic element prior to attachment of the device to the mounting surface (14).

16. A device as recited in claim 1, further comprising one or more rib-like elements provided to a surface of the monolithic structure opposite the LED light module engaging surface (20) to stiffen part of the device.

## Patentansprüche

1. Vorrichtung zum lösbaren Sichern eines LED Lichtmoduls, das eine oder mehrere LED Lichtquellen (12) aufweist, an einer Montagefläche (14), umfassend:
ein monolithisches Element (10), das aus spannkräftigem, metallischem Material hergestellt ist, das eine Öffnung (18) für die eine oder die mehreren LED Lichtquellen (12) aufweist, wobei die Öffnung (18) vollständig von einer flachen LED Lichtmoduleingriffsoberfläche (20) umgeben ist, die angeordnet ist, lösbar mit korrespondierenden Oberflächen des LED Lichtmoduls (12) einzugreifen,
wobei das monolithische Element (10) weiterhin eine integrierte, Kraft ausübende Feder in der Form von zumindest einem Paar von spannkräftigen oder blattfederähnlichen Befestigungslaschen (24) aufweist, von denen jede eine schlüsselförmige Befestigungsaufnahmeöffnung (26) aufweist,
wobei sich das zumindest eine Paar von Befestigungslaschen (24) von gegenüberliegenden Seiten der LED Lichtquelleeingriffsfläche (20) erstreckt,
wobei ein Eingriff zwischen den Befestigungslaschen (24) und einem korrespondierenden Befestigungsmittel (16) mit den korrespondierenden Oberflächen des LED Lichtmoduls (12), die in Eingriff mit der flachen LED Lichtmoduleingriffsoberfläche (20) positioniert sind, die flache LED Lichtmoduleingriffsoberfläche (20) unter Last bringt, so dass die flache Lichtmoduleingriffsoberfläche (20) eine grundsätzlich gleichmäßige Kraft auf die korrespondierende Oberfläche des LED Lichtmoduls (12) ausübt, um das LED Lichtmodul (12) an der Montagefläche (14) zu sichern, während zumindest ein kontinuierlicher Metallpfad zwischen der Montagefläche (14) und dem LED Lichtmodul (12) bereitgestellt wird.

2. Vorrichtung nach Anspruch 1, bei der jede des zumindest einen Paars von Befestigungslaschen (24) mit einem ersten Bereich (24a) vorgesehen ist, der sich von der Lichtquelleneingriffsoberfläche (20) in einem ersten Winkel erstreckt und einem zweiten Bereich (24b), der sich dann von dem Ende des ersten Bereichs (24a) in einem zweiten Winkel erstreckt, wo die schlüsselförmige Befestigungsaufnahmeöffnung (26) den ersten Bereich (24a) und den zweiten Bereich (24b) spannt.

3. Vorrichtung nach Anspruch 1, bei der die Vorrichtung angeordnet ist, um lösbar in einer installierten Position arretierbar zu sein, bei der das LED Lichtmodul (12) an der Montagefläche (14) gesichert ist.

4. Vorrichtung nach Anspruch 3, bei der die Vorrichtung angepasst ist, in einer hauptsächlich parallelen Richtung relativ zu der Montagefläche (14) eingeschoben zu sein, um die Vorrichtung von einer freien Position in die installierte Position zu verändern.

5. Vorrichtung nach Anspruch 3, bei der die Vorrichtung angepasst ist, in einer Ebene parallel zur Montagefläche (14) rotiert zu werden, um die Vorrichtung von einer freien Position in die installierte Position zu verändern.

6. Vorrichtung nach Anspruch 1, weiterhin umfassend ein Satz von ablenkbaren Armen (22), die mit dem monolithischen Element (10) verbunden sind, zum Packen eines Zusatzteils, das an der Vorrichtung anbringbar ist.

7. Vorrichtung nach Anspruch 1, weiterhin umfassend zumindest ein elektrisch isolierendes Gehäuse, das von dem monolithischen Element (10) getragen wird, wobei das zumindest eine elektrisch isolierende Gehäuse ein darin angeordnetes elektrisches Kontaktelement aufweist, wobei das elektrische Kontaktelement angeordnet ist, um elektrisch mit einem entsprechenden elektrischen Kontakt des LED Lichtmoduls (12) gekoppelt zu sein und um von dem monolithischen Element (10) elektrisch isoliert zu sein.

8. Vorrichtung nach Anspruch 7, bei der das zumindest eine elektrisch isolierende Gehäuse an einer Seite des monolithischen Elements (10) angebracht ist, die näher zu der Montagefläche (14) ist.

9. Vorrichtung nach Anspruch 7, bei der das elektrische Kontaktelement ein oder mehrere Bereiche umfasst, die generell vorgespannt sind, um in den entsprechenden elektrischen Kontakt des LED Lichtmoduls (12) einzugreifen.

10. Vorrichtung nach Anspruch 7, bei der das elektrische Kontaktelement mit einem oder mehreren Drähten verbunden ist.

11. Vorrichtung nach Anspruch 10, bei der das elektrische Kontaktelement zumindest einen Steckverbinder zum Eingreifen mit den einen oder mehreren Drähten aufweist.

12. Vorrichtung nach Anspruch 10, bei der die Vorrichtung weiterhin ein oder mehrere steuernde Elemente zum Positionieren des einen oder der mehreren Drähte durch einen Pfad umfasst.

13. Vorrichtung nach Anspruch 1, weiterhin umfassend ein oder mehrere Fixiermerkmale, die dem monolithischen Element (10), das mit einem Merkmal des LED Lichtmoduls (12) betreibbar ist, zugeordnet sind, zur Verwendung beim Fixieren des LED Lichtmoduls (12) in Eingriff mit der LED Lichtmodul-Eingriffsoberfläche (20).

14. Vorrichtung nach Anspruch 13, bei der zumindest eines der ein oder der mehreren Fixierelemente umgelenkt wird, wenn das LED Lichtmodul (12) in Eingriff mit der LED Lichtmodul-Eingriffsoberfläche (20) gebracht ist.

15. Vorrichtung nach Anspruch 13, bei der ein oder mehrere Fixierelemente das LED Lichtmodul (12) an dem monolithischen Element vor der Anbringung der Vorrichtung an der Montagefläche (14) halten und sichern.

16. Vorrichtung nach Anspruch 1, weiterhin umfassend ein oder mehrere rippenähnliche Elemente, die an einer Oberfläche der monolithischen Struktur gegenüber der LED Lichtmoduleingriffsoberfläche (20) vorgesehen sind, um einen Teil der Vorrichtung zu versteifen.

## Revendications

1. Dispositif pour fixer de manière détachable un module de lumière LED, présentant une ou plusieurs sources de lumière LED (12), sur une surface de montage (14), comprenant :
un élément monolithique (10) construit à partir d'un matériau métallique résilient présentant une ouverture (18) pour l'une ou les plusieurs sources de lumière LED (12), dans lequel l'ouverture (18) est entièrement entourée par une surface d'engagement de module de lumière LED (20) agencée pour engager de manière détachable des surfaces correspondantes du module de lumière LED (12), l'élément monolithique (10) présentant en outre un ressort d'application de force intégré sous la forme d'au moins une paire de pattes de montage résilientes ou de type ressort à lames (24) présentant chacune une ouverture de réception d'élément de fixation en forme de clé (26),
dans lequel l'au moins une paire de pattes de montage (24) s'étend depuis des côtés en regard de la surface d'engagement de source de lumière LED (20),
dans lequel un engagement entre les pattes de montage (24) et un élément de fixation (16) correspondant avec les surfaces correspondantes du module de lumière LED (12) positionné en engagement avec la surface d'engagement de module de lumière LED planaire (20) place la surface d'engagement de module de lumière LED planaire (20) sous charge de sorte que la surface d'engagement de module de lumière LED planaire (20) applique une force généralement uniforme sur la surface correspondante du module de lumière LED (12) pour fixer le module de lumière LED (12) sur la surface de montage (14) tout en fournissant au moins une voie métallique continue entre la surface de montage (14) et le module de lumière LED (12).

2. Dispositif selon la revendication 1, dans lequel chacune de l'au moins une paire de pattes de montage (24) est dotée d'une première partie (24a) qui s'étend depuis la surface d'engagement de source de lumière LED (20) selon un premier angle et une seconde partie (24b) qui s'étend ensuite depuis l'extrémité de la première partie (24a) selon un second angle où l'ouverture d'acceptation d'élément de fixation en forme de clé (26) couvre la première partie (24a) et la seconde partie (24b).

3. Dispositif selon la revendication 1, dans lequel le dispositif est agencé pour être verrouillable de manière détachable dans une position installée, dans laquelle le module de lumière LED (12) est fixé sur la surface de montage (14).

4. Dispositif selon la revendication 3, dans lequel le dispositif est adapté pour être coulissé dans une direction généralement parallèle par rapport à la surface de montage (14) pour faire passer le dispositif depuis une position libre à la position installée.

5. Dispositif selon la revendication 3, dans lequel le dispositif est adapté pour être tourné dans un plan parallèle à la surface de montage (14) pour faire passer le dispositif depuis une position libre à la position installée.

6. Dispositif selon la revendication 1, comprenant en outre un ensemble de bras flexibles (22) couplés à l'élément monolithique (10) pour saisir un accessoire attachable au dispositif.

7. Dispositif selon la revendication 1, comprenant en outre au moins un boîtier électroisolant porté par l'élément monolithique (10), l'au moins un boîtier électroisolant présentant un élément de contact électrique disposé dedans, l'élément de contact électrique étant agencé pour être couplé électriquement à un contact électrique correspondant du module de lumière LED (12) et pour rester isolé électriquement de l'élément monolithique (10).

8. Dispositif selon la revendication 7, dans lequel l'au moins un boîtier électroisolant est attaché à un côté de l'élément monolithique (10) qui est plus près de la surface de montage (14).

9. Dispositif selon la revendication 7, dans lequel l'élément de contact électrique comprend une ou plusieurs parties qui sont généralement inclinées pour engager le contact électrique correspondant du module de lumière LED (12).

10. Dispositif selon la revendication 7, dans lequel l'élément de contact électrique est relié à un ou plusieurs fils.

11. Dispositif selon la revendication 10, dans lequel l'élément de contact électrique comprend au moins un connecteur à emboîtement pour engager l'un ou les plusieurs fils.

12. Dispositif selon la revendication 10, dans lequel le dispositif comprend en outre un ou plusieurs éléments d'acheminement pour positionner l'un ou les plusieurs fils au travers d'une voie.

13. Dispositif selon la revendication 1, comprenant en outre un ou plusieurs éléments de localisation associés à l'élément monolithique (10) coactionnables avec un élément du module de lumière LED (12) pour l'utilisation lors de la localisation du module de lumière LED (12) en engagement avec la surface d'engagement de module de lumière LED (20).

14. Dispositif selon la revendication 13, dans lequel au moins un de l'un ou des plusieurs éléments de localisation est dévié lorsque le module de lumière LED (12) est placé en engagement avec la surface d'engagement de module de lumière LED (20).

15. Dispositif selon la revendication 13, dans lequel l'un ou les plusieurs éléments de localisation maintiennent et fixent le module de lumière LED (12) à l'élément monolithique avant l'attache du dispositif à la surface de montage (14).

16. Dispositif selon la revendication 1, comprenant en outre un ou plusieurs éléments à nervure prévus sur une surface de la structure monolithique en regard de la surface d'engagement de module de lumière LED (20) pour renforcer une partie du dispositif.
